# EUROPEAN PATENT APPLICATION

(11) **EP 2 642 530 A1**
(43) Date of publication of application: **25.09.2013**
(21) Application number: 11840909.3
(22) Date of filing: 16.11.2011
(51) Int. Cl.: H01L 31/09, G01T 1/24, H01J 29/45, H01J 31/49, H01L 27/14, H04N 5/32

(54) **X-RAY SENSOR, METHOD FOR TESTING THE X-RAY SENSOR, AND X-RAY DIAGNOSTIC DEVICE EQUIPPED WITH THE X-RAY SENSOR**

(30) Priority: 17.11.2010 JP 2010256365; 17.11.2010 JP 2010256366
(71) Applicant: Panasonic Corporation, Osaka 571-8501 (JP); Nippon Hoso Kyokai, Tokyo 150-0041 (JP)
(72) Inventor: JOUNO, Masahiro, Osaka-shi, Osaka 540-6207 (JP); KOGA, Keisuke, Osaka-shi, Osaka 540-6207 (JP); OHKAWA, Yuji, Tokyo 157-8510 (JP); KUBOTA, Misao, Tokyo 157-8510 (JP); MIYAKAWA, Kazunori, Tokyo 157-8510 (JP); TANIOKA, Kenkichi c/o Nippon Hoso Kyokai Science &, Tokyo 157-8510 (JP)
(74) Representative: Grünecker, Kinkeldey, Stockmair & Schwanhäusser
(86) International application number: PCT/JP2011/006368
(87) International publication number: WO 2012/066771

(57) **Abstract**

An X-ray sensor according to the present invention includes: a light-transmissive substrate (17); a light-transmissive electrode (21) formed on one surface of the light-transmissive substrate (17); and a photoconductive film (18) including a hole injection blocking layer (22), a field buffer layer (23), a hole trap layer (24), a photoconductive sensitive layer (25) having a charge-multiplying function, and an electron injection blocking layer (26), the layers being sequentially provided on the one surface of the light-transmissive substrate (17) having the light-transmissive electrode (21). The field buffer layer (23) is larger in thickness than a layer composed of the light-transmissive electrode (21) and the hole injection blocking layer (22).

## Description

### Technical Field

The present invention relates to an X-ray sensor, a method for testing the X-ray sensor, and an X-ray diagnostic device equipped with the X-ray sensor.

### Background Art

An X-ray diagnostic device includes an X-ray source and an X-ray sensor. The X-ray sensor is located at a predetermined distance from the X-ray source so as to be opposed to the X-ray source. Specifically, the X-ray source and the X-ray sensor are located such that X-rays from the X-ray source are emitted to a human body and then are incident on the X-ray sensor through the human body. The X-ray diagnostic device irradiates the human body with X-rays to visualize the internal condition of the human body. Since the human body is irradiated with X-rays in the X-ray diagnostic device, a minimum amount of X-ray irradiation is preferable. Thus, the sensitivity of the X-ray sensor needs to be improved in the X-ray diagnostic device.

In a method for improving the sensitivity of the X-ray sensor, the X-ray sensor may be an imaging device including a photoconductive target portion having a blocking structure with a charge-multiplying function. Such an imaging device is proposed in, for example, Patent Literature 1.

Specifically, the imaging device includes a hole injection blocking layer, an electron injection blocking layer, and a photoconductive sensitive layer interposed between the blocking layers. Light incident on the photoconductive sensitive layer generates charge in the layer. The sensitive layer is made of a material that multiplies charge when being subjected to high fields. Patent Literature 1 proposes a sensitive layer composed of an amorphous semiconductor that consists principally of Se. The imaging device can capture an image with high sensitivity even in the case of a small light quantity.

Thus, the sensitivity of an X-ray sensor can be improved by forming, in the X-ray sensor, a photoconductive film including the hole injection blocking layer, the electron injection blocking layer, and the photoconductive sensitive layer having the charge-multiplying function between the blocking layers.

### Citation List

### Patent Literature

Patent Literature 1: Japanese Patent Laid-Open No. 63-304551

### Summary of Invention

### Technical Problem

In the known technique, however, scratches or irregularities on the hole injection blocking layer may lead to insufficient blocking of hole injection. In other words, holes from a high voltage power supply pass through scratches or irregularities on the hole injection blocking layer and then reach the sensitive layer, causing white scratches on a captured image in the known technique.

Scratches or irregularities on the hole injection blocking layer are mainly caused by small dust remaining on a light-transmissive substrate. Specifically, dust on the light-transmissive substrate may cause irregularities transferred to a thin light-transmissive electrode, resulting in scratches or irregularities on the hole injection blocking layer.

X-ray sensor in an X-ray diagnostic device requires quite a large area. For example, in an X-ray diagnostic device for mammography, an X-ray sensor includes a rectangular sensor surface having a side length of about 200 mm to 250 mm in plan view. In an X-ray diagnostic device for a chest, an X-ray sensor includes a rectangular sensor surface having a side length of about 450 mm in plan view. In the fabrication of the X-ray sensor having a large area, dust cannot be completely removed from a light-transmissive substrate, causing scratches or irregularities partially on a photoconductive film.

In view of the problem, an object of the present invention is to provide an X-ray sensor that can reduce the number of white scratches caused by scratches or irregularities on a hole injection blocking layer, a method for testing the X-ray sensor, and an X-ray diagnostic device equipped with the X-ray sensor.

### Solution to Problem

In order to attain the object, an aspect of an X-ray sensor according to the present invention includes: a light-transmissive substrate; a light-transmissive electrode formed on a first surface of the light-transmissive substrate; and a photoconductive film including a hole injection blocking layer, a field buffer layer, a hole trap layer, a photoconductive sensitive layer having a charge-multiplying function, and an electron injection blocking layer, the layers being sequentially provided on the first surface of the light-transmissive substrate having the light-transmissive electrode, wherein the field buffer layer is larger in thickness than a layer composed of the light-transmissive electrode and the hole injection blocking layer.

According to the X-ray sensor of the present invention, even if scratches or irregularities occur on the hole injection blocking layer, holes from a high voltage power supply for supplying a high voltage to the light-transmissive electrode can be trapped in the hole trap layer. Furthermore, the trapping of the holes can buffer an electric field between the light-transmissive electrode and the hole trap layer. According to the present invention, the field buffer layer can expand a field buffer region. Furthermore, according to the present invention, the field buffer layer is larger in thickness than the layer composed of the light-transmissive electrode and the hole injection blocking layer, so that the field buffer layer can be larger in thickness than the field buffer layer of a visible light sensor, thereby more effectively buffering an electric field than in the visible light sensor. Thus, the present invention can reduce the number of white scratches caused by scratches or irregularities on the hole injection blocking layer.

Another aspect of the X-ray sensor according to the present invention further includes a bias light source that irradiates a second surface of the light-transmissive substrate with light, the second surface being located opposite to the first surface so as to receive X-rays. With this configuration, an electric field can be more effectively buffered by the hole trap layer using the bias light source, thereby reliably reducing the number of white scratches caused by scratches or irregularities on the hole injection blocking layer. Furthermore, the field buffer effect of the hole trap layer can be stably obtained over the sensor surface of the X-ray sensor by using the bias light source, thereby preventing the field buffer effect in the sensor surface of the X-ray sensor from varying with the history of X-ray irradiation. Thus, the X-ray sensor can be obtained with constant sensitivity.

An aspect of a method for testing an X-ray sensor according to the present invention is a method for testing the X-ray sensor of the present invention, the method including: a first step of, in a state in which the light-transmissive electrode is fed with a voltage so as to apply an electric field to the photoconductive film, emitting red light to the second surface of the light-transmissive substrate, the second surface being located opposite to the first surface so as to receive X-rays; and a second step of collecting an electric signal from the photoconductive film according to the amount of charge generated on the sensitive layer of the photoconductive film by the irradiation of the red light.

According to the method for testing the X-ray sensor of the present invention, red light having a wavelength of 620 nm that is visual light can be used instead of X-rays when the quality of the X-ray sensor is evaluated. Specifically, since red light can pass through the field buffer layer having a thickness of 6 µm or less, the quality of the X-ray sensor can be evaluated using red light when the field buffer layer has a thickness of 6 µm or less. Thus, a defect (black scratch or white scratch) on the photoconductive film of the X-ray sensor can be evaluated by irradiating the X-ray sensor with red light.

An X-ray diagnostic device according to the present invention is equipped with the X-ray sensor according to the present invention, the X-ray sensor being located at a predetermined distance from an X-ray source so as to be opposed to the X-ray source.

### Advantageous Effects of Invention

The X-ray sensor according to the present invention can reduce the number of white scratches caused by scratches or irregularities on the hole injection blocking layer.

According to the method for testing the X-ray sensor of the present invention, the quality of the X-ray sensor can be evaluated using red light. Thus, the quality of the X-ray sensor can be more easily evaluated than in a testing method using X-rays.

### Brief Description of Drawings

[FIG. 1] FIG. 1 is a structural diagram illustrating an X-ray diagnostic device according to an embodiment of the present invention.
[FIG. 2] FIG. 2 is a block diagram illustrating the X-ray diagnostic device according to the embodiment of the present invention.
[FIG. 3] FIG. 3 is a perspective view illustrating the appearance of an X-ray sensor according to the embodiment of the present invention.
[FIG. 4] FIG. 4 is a cross-sectional view illustrating the X-ray sensor according to the embodiment of the present invention.
[FIG. 5] FIG. 5 is a structural diagram illustrating a photoconductive film included in the X-ray sensor according to the embodiment of the present invention.
[FIG. 6] FIG. 6 is a control block diagram illustrating the X-ray sensor according to the embodiment of the present invention.
[FIG. 7] FIG. 7 is a characteristic diagram showing the X-ray sensor according to the embodiment of the present invention.
[FIG. 8] FIG. 8 is a characteristic diagram showing the X-ray sensor according to the embodiment of the present invention.
[FIG. 9] FIG. 9 is a characteristic diagram showing the X-ray sensor according to the embodiment of the present invention.
[FIG. 10] FIG. 10 shows the relationship between the thickness of a field buffer layer and the number of occurrences of white scratches according to the embodiment of the present invention.
[FIG. 11] FIG. 11 shows the relationship between the thickness of the field buffer layer and the wavelength of light emitted from a bias light source according to the embodiment of the present invention.
[FIG. 12] FIG. 12 is a control block diagram in the testing of the X-ray sensor according to the embodiment of the present invention.
[FIG. 13] FIG. 13 is a cross-sectional view illustrating an X-ray sensor according to another embodiment of the present invention.

### Description of Embodiments

An embodiment of an X-ray sensor, a method for testing the X-ray sensor, and an X-ray diagnostic device equipped with the X-ray sensor according to the present invention will be described below with reference to the accompanying drawings. The accompanying drawings are schematically or conceptually illustrated for understanding. The same constituent elements are indicated by the same reference numerals and may not be further described herein.

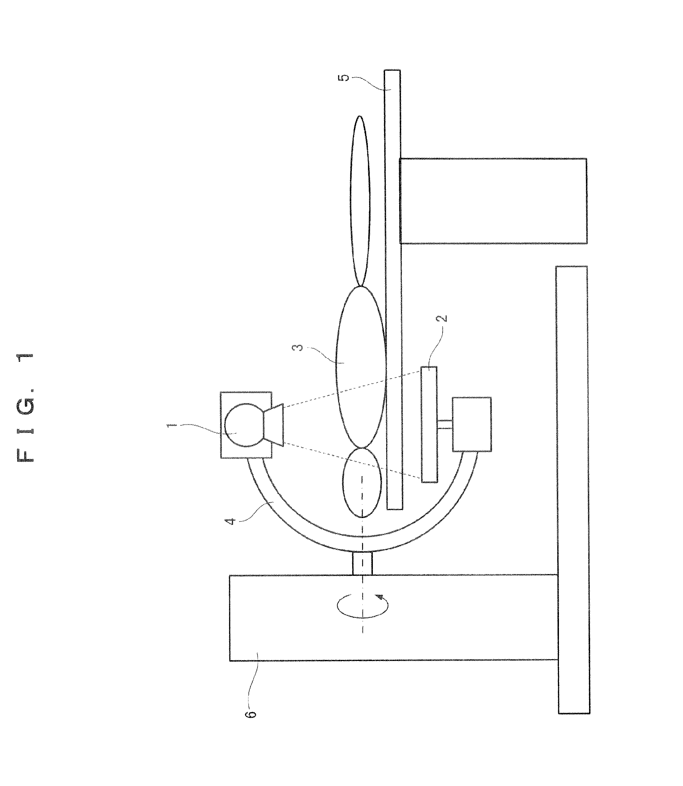

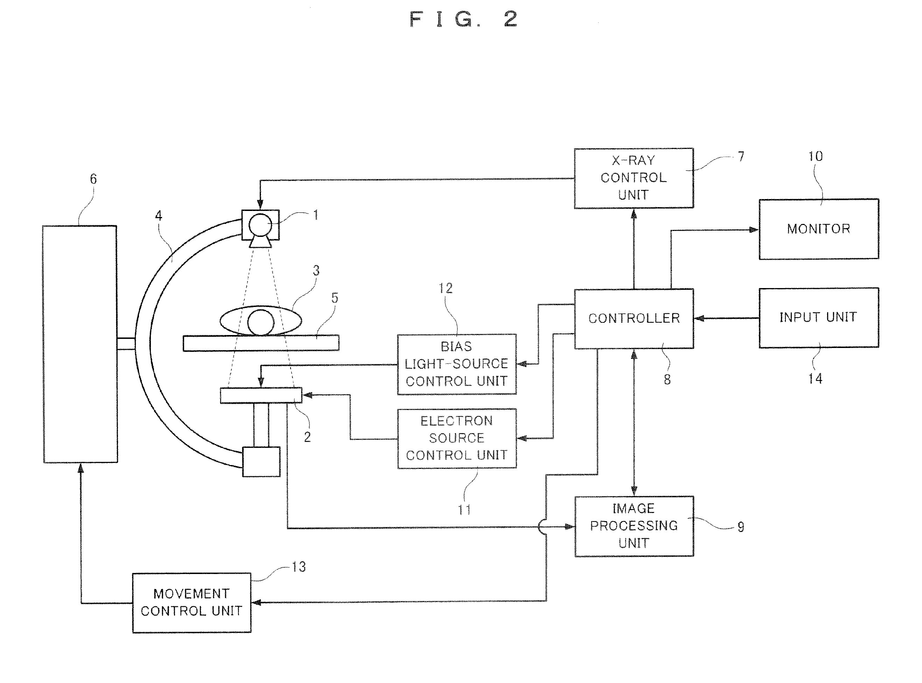

Referring to FIGS. 1 and 2, the overall configuration of the X-ray diagnostic device will be described below according to the present embodiment.

FIG. 1 is a structural diagram showing the X-ray diagnostic device according to the embodiment of the present invention. As shown in FIG. 1, the X-ray diagnostic device includes an X-ray source 1 and an X-ray sensor 2. The X-ray sensor 2 is located at a predetermined distance from the X-ray source 1 so as to be opposed to the X-ray source 1. Specifically, the X-ray source 1 and the X-ray sensor 2 are located such that X-rays from the X-ray source 1 are emitted to a subject 3 and then are incident on the X-ray sensor 2 through the subject 3. The X-ray diagnostic device irradiates the subject 3 with X-rays to visualize the internal condition of the subject 3.

More specifically, the X-ray source 1 is provided on one end of an arm 4, which is substantially semicircular in side view, while the X-ray sensor 2 is provided on another end of the arm 4. In this way, the X-ray source 1 and the X-ray sensor 2 are opposed to each other at the predetermined distance. Thus, the arm 4 allows the X-ray source 1 and the X-ray sensor 2 to oppose each other with the subject 3 laid on a bed 5 between the X-ray source 1 and the X-ray sensor 2, allowing the X-ray sensor 2 to detect X-rays having passed through the subject 3 from the X-ray source 1.

The arm 4 is rotatably attached to a main unit case 6. The main unit case 6 contains a drive unit (not shown) for rotating the arm 4. This configuration makes it possible to visualize the internal condition of the subject 3 from various angles.

FIG. 2 is a block diagram illustrating the X-ray diagnostic device according to the embodiment of the present invention.

As shown in FIG. 2, the X-ray source 1 is connected to an X-ray control unit 7 that is connected to a controller 8. The controller 8 controls the overall operation of the X-ray diagnostic device. The X-ray control unit 7 controls X-ray irradiation from the X-ray source 1 and the amount of X-ray irradiation from the X-ray source 1 in response to a command signal from the controller 8.

The X-ray sensor 2 is connected to an image processing unit 9. The image processing unit 9 detects an electric signal (photoelectric conversion signal) collected from the X-ray sensor 2 and performs image processing on the signal. The signal processed by the image processing unit 9 is transmitted to the controller 8. The controller 8 displays an image on a monitor 10 according to the light quantity (intensity) of X-rays detected by the X-ray sensor 2. The image displayed on the monitor 10 shows the internal condition of the subject 3.

The X-ray sensor 2 is also connected to an electron source control unit 11. The electron source control unit 11 is connected to the controller 8. The electron source control unit 11 controls the irradiation of electron beams from an electron source, which will be described later, and the amount of irradiation of electron beams from the electron source in response to a command signal from the controller 8.

The X-ray sensor 2 is also connected to a bias light-source control unit 12. The bias light-source control unit 12 is connected to the controller 8. The bias light-source control unit 12 controls the irradiation of light (bias light) from a bias light source, which will be described later, and the amount of irradiation of light from the bias light source in response to a command signal from the controller 8.

The drive unit (not shown) contained in the main unit case 6 to rotate the arm 4 is connected to a movement control unit 13 that is connected to the controller 8. The movement control unit 13 controls the rotating operation of the arm 4 in response to a command signal from the controller 8.

The controller 8 is also connected to an input unit 14. The controller 8 controls the overall operation of the X-ray diagnostic device in response to a command inputted from the input unit 14.

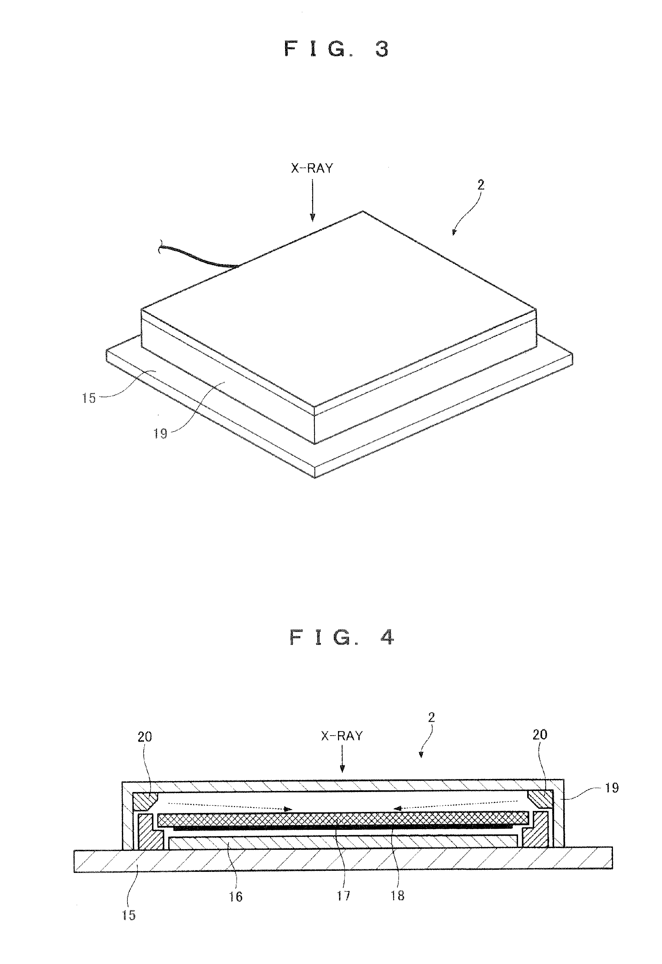

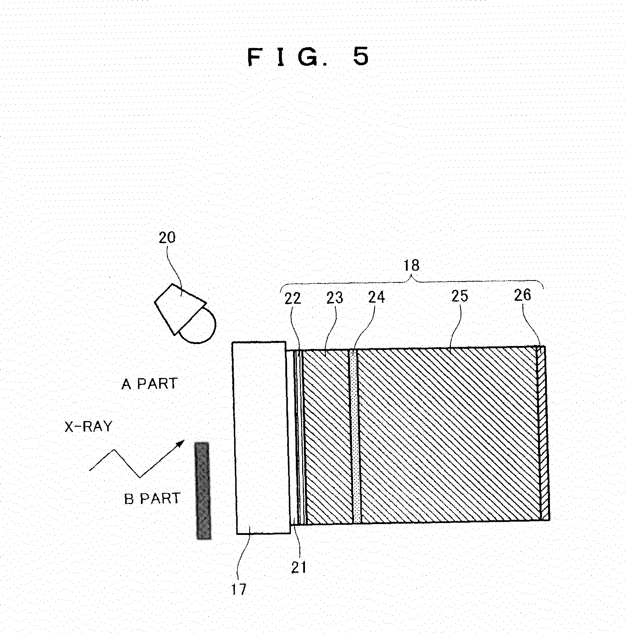

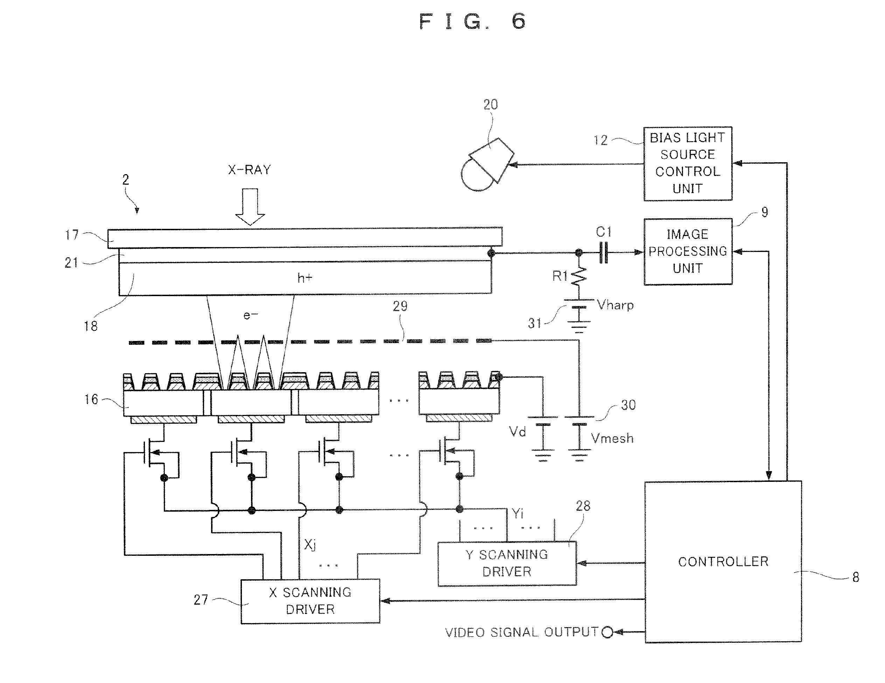

Referring to FIGS. 3 to 6, the X-ray sensor 2 according to the present embodiment will be described below. FIG. 3 is a perspective view illustrating the appearance of the X-ray sensor according to the embodiment of the present invention. FIG. 4 is a cross-sectional view illustrating the X-ray sensor according to the embodiment of the present invention. FIG. 5 is a structural diagram illustrating a photoconductive film included in the X-ray sensor according to the embodiment of the present invention. FIG. 6 is a control block diagram illustrating the X-ray sensor according to the embodiment of the present invention.

As shown in FIGS. 3 and 4, the X-ray sensor 2 includes a mounting substrate 15 that is rectangular in plan view. As shown in FIG. 4, on the major surface of the mounting substrate 15, an electron source 16 is provided that is rectangular in plan view like the mounting substrate 15. A light-transmissive substrate 17 is disposed above the electron source 16, on the opposite side from the mounting substrate 15.

Specifically, the light-transmissive substrate 17 on the opposite side from the mounting substrate 15 has a first surface including a light-transmissive electrode (not shown) and a second surface that is opposite to the first surface including the light-transmissive electrode, the second surface receiving X-rays (X-ray incidence surface). Thus, the light-transmissive substrate 17 is disposed on the opposite side from the mounting substrate 15 such that the first surface including the light-transmissive electrode faces the electron source 16. Furthermore, a photoconductive film 18 is provided on the first surface of the light-transmissive substrate 17 including the light-transmissive electrode.

As illustrated in FIGS. 3 and 4, the electron source 16 and the light-transmissive substrate 17 on the major surface of the mounting substrate 15 are covered with a cover 19. The cover 19 contains a bias light source 20 that irradiates the X-ray incidence surface of the light-transmissive substrate 17 with light (bias light). The bias light source 20 is desirably placed outside the projection region of the light-transmissive substrate 17.

As illustrated in FIG. 5, the photoconductive film 18 includes a hole injection blocking layer 22, a field buffer layer 23, a hole trap layer 24 that traps holes generated by the irradiation of X-rays and visible light, a photoconductive sensitive layer 25 having a charge-multiplying function, and an electron injection blocking layer 26. These layers are sequentially provided on the first surface of the light-transmissive substrate 17, the first surface having a light-transmissive electrode 21. Thus, the light-transmissive substrate 17 is disposed on the opposite side from the mounting substrate 15 such that the surface of the electron injection blocking layer 26 of the photoconductive film 18 faces the electron source 16. With this configuration, the electron source 16 can irradiate the surface of the electron injection blocking layer 26 of the photoconductive film 18 with electron beams.

The light-transmissive electrode 21 is made of materials such as indium tin oxide (ITO) and tin oxide. The hole injection blocking layer 22 is made of ceric oxide (CeO₂), the field buffer layer 23 is made of amorphous selenium (a-Se), the hole trap layer 24 is made of amorphous selenium (a-Se) and lithium fluoride (LiF), the sensitive layer 25 is made of amorphous selenium (a-Se), and the electron injection blocking layer 26 is made of antimony trisulfide (Sb₂S₃).

In the present embodiment, the photoconductive film 18 includes the field buffer layer 23 and the hole trap layer 24 in order to reduce the number of white scratches caused by scratches or irregularities on the hole injection blocking layer 22.

Specifically, if scratches or irregularities occur on the hole injection blocking layer 22, a high voltage applied to the light-transmissive electrode 21 from a high voltage power supply connected to the light-transmissive electrode 21 allows holes to pass through the scratches or irregularities on the hole injection blocking layer 22 into the photoconductive film 18. Hence, in the case where the hole injection blocking layer 22 and the sensitive layer 25 are adjacent to each other, holes flowing in the photoconductive film 18 are accelerated and multiplied by the internal field of the photoconductive film 18, causing white scratches. To address this problem, the hole trap layer 24 is provided between the hole injection blocking layer 22 and the sensitive layer 25. This configuration makes it possible to trap holes in the hole trap layer 24, and the trapping of holes can buffer an electric field between the light-transmissive electrode 21 and the hole trap layer 24. Hence, even if the hole injection blocking layer 22 has scratches or irregularities, holes flowing from the high voltage power supply are unlikely to reach the sensitive layer 25, reducing the number of white scratches on a captured image.

Moreover, in the present embodiment, the field buffer layer 23 is disposed between the hole injection blocking layer 22 and the hole trap layer 24. This configuration makes it possible to increase a field buffer region between the light-transmissive electrode 21 and the hole trap layer 24, allowing the field buffer layer 23 to further reduce the number of occurrences of white scratches.

Furthermore, in the present embodiment, the field buffer layer 23 is larger in thickness than a layer composed of the light-transmissive electrode 21 and the hole injection blocking layer 22. With this configuration, the field buffer layer 23 can be larger in thickness than the field buffer layer of a visible light sensor (about 30 nm). Thus, an electric field can be more effectively buffered than in the visible light sensor. Also in the visible light sensor, a light-transmissive electrode is made of materials such as indium tin oxide (ITO) and tin oxide, a hole injection blocking layer is made of ceric oxide (CeO₂), a field buffer layer is made of amorphous selenium (a-Se), a hole trap layer is made of amorphous selenium (a-Se) and lithium fluoride (LiF), a sensitive layer is made of amorphous selenium (a-Se), and an electron injection blocking layer is made of antimony trisulfide (Sb₂S₃).

In the present embodiment, the bias light source 20 is provided to allow the hole trap layer 24 to effectively buffer an electric field. Specifically, the X-ray incidence surface of the light-transmissive substrate 17 is irradiated with light (bias light) from the bias light source 20 before X-ray irradiation. Thus, holes generated by light from the bias light source 20 can be trapped in the hole trap layer 24 so as to buffer an electric field. This can reduce the influence of scratches or irregularities on the sensitive layer 25.

As shown in FIG. 6, the electron source 16 receives a voltage Vd for emitting electron beams. The electron source 16 is connected to an X scanning driver 27 and a Y scanning driver 28. The X scanning driver 27 and the Y scanning driver 28 are both contained in the electron source control unit 11. Thus, the electron source 16 is controlled by the X scanning driver 27 and the Y scanning driver 28 so as to scan electron beams on the surface of the electron injection blocking layer 26 of the photoconductive film 18.

As shown in FIG. 6, the X-ray sensor 2 may include a mesh 29 having a plurality of openings. The mesh 29 is an intermediate electrode that accelerates electron beams emitted from the electron source 16, focuses the electron beams, and collects excessive electrons. The mesh 29 is connected to a mesh voltage applying unit 30 contained in the electron source control unit 11. The mesh voltage applying unit 30 applies a positive voltage (mesh voltage) Vmesh to the mesh 29. The mesh 29 can be made of a known metallic material, alloy, and semiconductor material, and so on.

The light-transmissive electrode 21 is connected to a high voltage source 31 for supplying a high voltage Vharp. The high voltage Vharp applies a high electric field to the sensitive layer 25 of the photoconductive film 18. The light-transmissive electrode 21 is connected to the image processing unit 9. As has been discussed, the image processing unit 9 detects a photoelectric conversion signal from the light-transmissive electrode 21 and performs image processing on the signal. The level of the photoelectric conversion signal varies with the quantity (intensity) of light incident on the X-ray incidence surface of the light-transmissive substrate 17.

The operation of the X-ray diagnostic device will be described below according to the present embodiment. In the present embodiment, before the subject 3 undergoes radiography, the overall X-ray incidence surface of the light-transmissive substrate 17 is uniformly irradiated with light (bias light) from the bias light source 20.

The initial operation is performed to more effectively buffer an electric field by the hole trap layer 24. specifically, the X-ray incidence surface of the light-transmissive substrate 17 is irradiated with bias light to trap a sufficient amount of holes in the hole trap layer 24, effectively buffering an electric field before radiography.

For example, as illustrated in FIG. 5, an A part not containing the subject is formed in front of the X-ray incidence surface of the light-transmissive substrate 17 and a B part containing the subject with low X-ray transmittance is formed in front of the X-ray incidence surface of the light-transmissive substrate 17. Even in this case, before the subject 3 undergoes radiography, bias light is uniformly emitted at least to a region in which the photoconductive film 18 is projected on the X-ray incidence surface of the light-transmissive substrate, so that an electric field can be buffered by the hole trap layer 24 with stability over the sensor surface of the X-ray sensor 2.

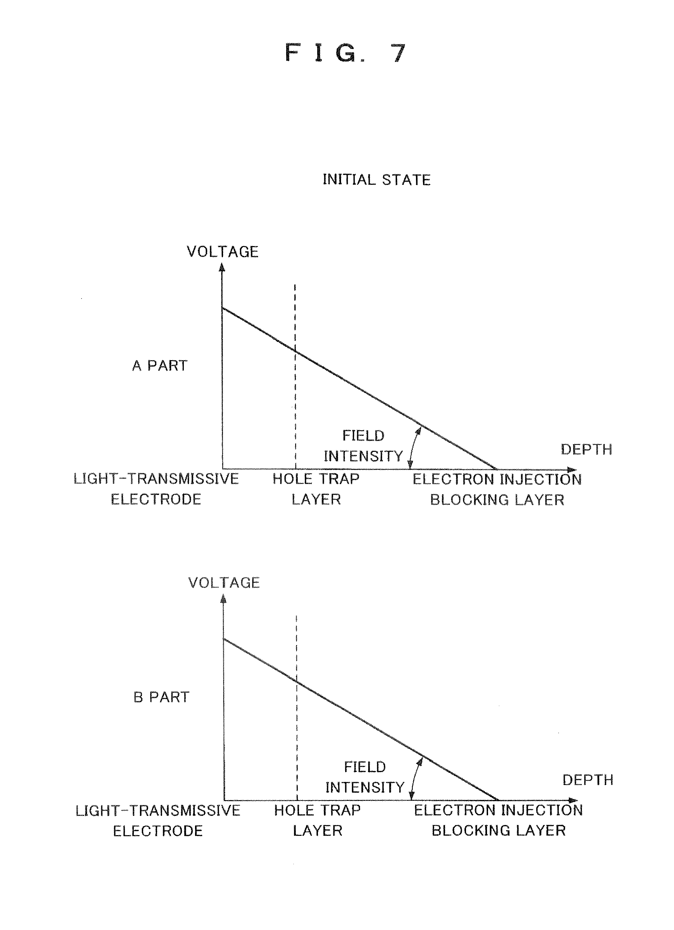

For example, as illustrated in FIG. 5, the A part not containing the subject is formed in front of the X-ray incidence surface of the light-transmissive substrate 17 and the B part containing the subject with low X-ray transmittance is formed in front of the X-ray incidence surface of the light-transmissive substrate 17. Before the subject 3 undergoes radiography, the initial operation is performed to uniformly irradiate the X-ray incidence surface of the light-transmissive substrate 17 with bias light. Referring to FIGS. 7 to 9, the reason for the initial operation will be specifically described below. In FIGS. 7 to 9, voltage distributions from the light-transmissive electrode 21 to the electron injection blocking layer 26 are vertically shown for the respective A and B parts illustrated in FIG. 5.

In an initial state, as shown in FIG. 7, an electric field is not buffered because holes are not trapped in the hole trap layer 24. A voltage from the light-transmissive electrode 21 to the electron injection blocking layer 26 in the A and B parts linearly declines in the depth direction of the photoconductive film 18.

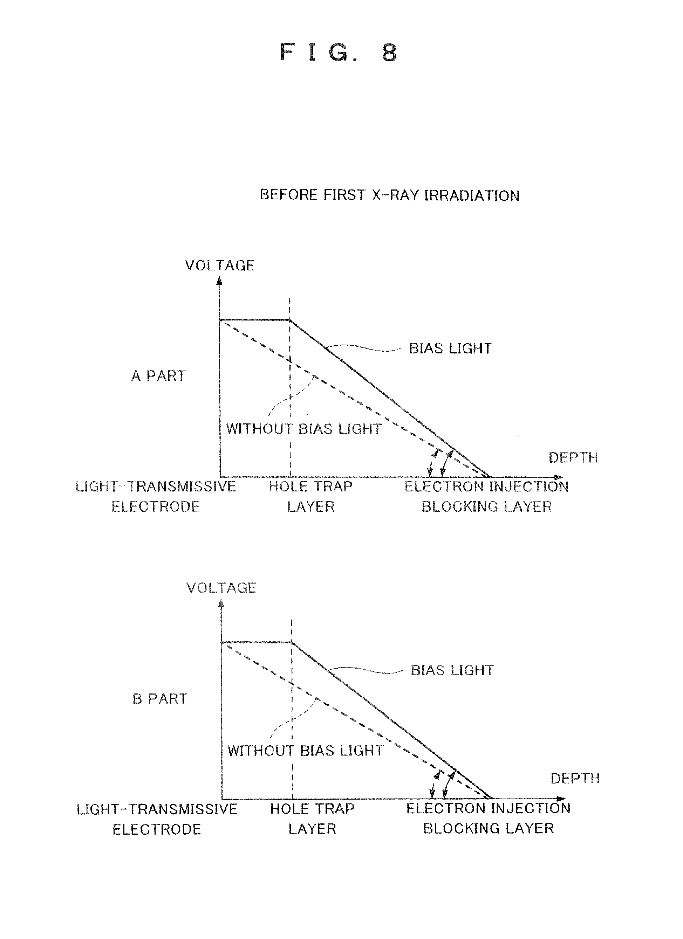

From the initial state to first X-ray irradiation, bias light is uniformly emitted at least to the overall region in which the photoconductive film 18 is projected on the X-ray incidence surface of the light-transmissive substrate 17. In this case, as indicated by solid lines in FIG. 8, a sufficient amount of holes is trapped in the hole trap layer 24 so as to buffer an electric field in the A and B parts. Specifically, the voltage of the hole trap layer 24 increases, the light-transmissive electrode 21 and the hole trap layer 24 have substantially the same voltage, and an electric field between the light-transmissive electrode 21 and the hole trap layer 24 is substantially eliminated. The increased voltage of the hole trap layer 24 leads to a rapid change in voltage from the hole trap layer 24 to the electron injection blocking layer 26 in the A and B parts.

In the case where bias light is not emitted, as indicated by broken lines in FIG. 8, a voltage from the light-transmissive electrode 21 to the electron injection blocking layer 26 in the A and B parts linearly declines in the depth direction of the photoconductive film 18 as in the initial state.

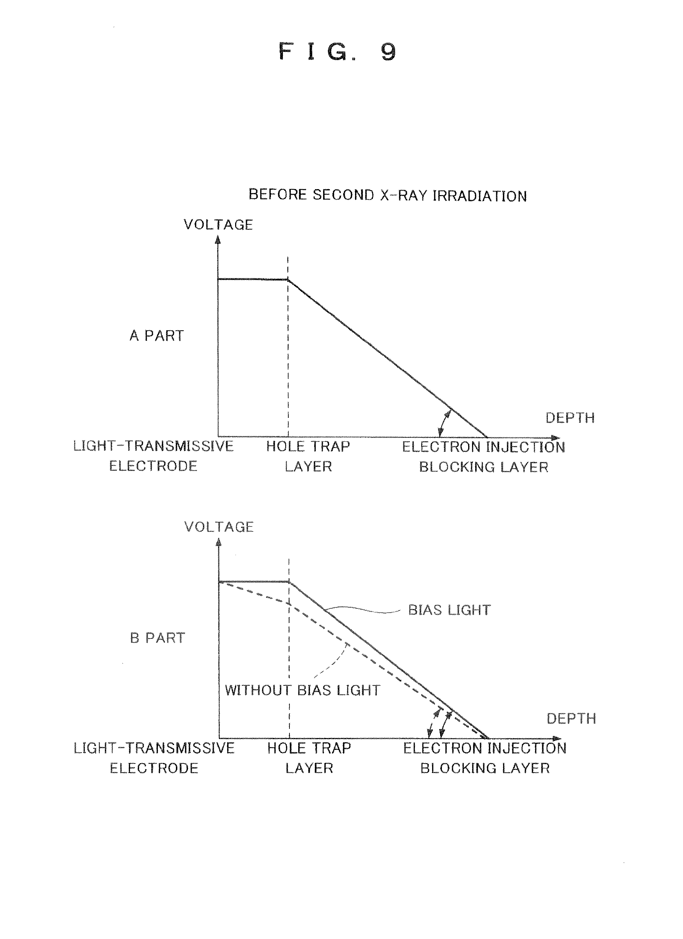

After the first X-ray irradiation, that is, before second X-ray irradiation, a sufficient amount of holes is trapped in the hole trap layer 24 in the A part by the first X-ray irradiation, thereby buffering an electric field in the A part as shown in FIG. 9. Thus, even if the light-transmissive substrate 17 is not irradiated with bias light, an electric field is buffered in the A part by the X-ray radiation.

In the B part, however, an insufficient amount of holes is generated by X-ray irradiation and then is trapped by the hole trap layer 24. Thus, the absence of bias light irradiation results in imperfect field buffer. In the B part, as indicated by a broken line in FIG. 9, the voltage of the hole trap layer 24 slightly increases, whereas a voltage between the light-transmissive electrode 21 and the hole trap layer 24 linearly decreases in the depth direction of the photoconductive film 18. Thus, a voltage from the hole trap layer 24 to the electron injection blocking layer 26 does not rapidly change as in the A part.

The absence of bias light irradiation causes a difference between the A and B parts in the amount of holes that are generated by X-ray irradiation and are trapped by the hole trap layer 24, leading to variations in potential from the light-transmissive electrode 21 to the hole trap layer 24. In other words, the field buffer effect of the hole trap layer 24 varies between the A and B parts. Consequently, a voltage fluctuation from the hole trap layer 24 to the electron injection blocking layer 26 varies between the A and B part, leading to a difference between the A and B parts in the field intensity of the sensitive layer 25 disposed between the hole trap layer 24 and the electron injection blocking layer 26. The field intensity of the sensitive layer 25 is closely associated with the sensitivity of the sensitive layer 25. Thus, a difference between the A and B parts in the field intensity of the sensitive layer 25 causes a difference in signal level between the A and B parts even in the radiography of the same subject. In other words, the absence of bias light irradiation leads to the influence of the history of previous subjects.

In contrast, bias light as in the initial X-ray irradiation is emitted before the second X-ray irradiation, achieving the field buffer effect both in the A and B parts. Thus, as indicated by solid lines in FIG. 9, a voltage can be rapidly changed from the hole trap layer 24 to the electron injection blocking layer 26 both in the A and B parts.

As has been discussed, bias light irradiation before X-ray irradiation allows the hole trap layer 24 to have an enhanced field buffer effect. Furthermore, an X-ray sensor with constant sensitivity can be obtained without being affected by the history of irradiation. In particular, as the field buffer layer 23 increases in thickness, the effect of bias light is improved. Specifically, as shown in FIG. 9, the absence of bias light irradiation causes a difference in field intensity between the A and B parts, the field intensity serving as a change in voltage from the hole trap layer 24 to the electron injection blocking layer 26. The difference in field intensity between the A and B parts increases as the field buffer layer 23 increases in thickness. Therefore, an increase in the thickness of the field buffer layer 23 results in the greater variation of a field buffer effect in the plane of the sensor due to the history of previous subjects, which increases the influence of the history of irradiation. Thus, an increase in the thickness of the field buffer layer 23 results in an unstable field buffer effect. In contrast, bias light irradiation can substantially equalize a voltage from the light-transmissive electrode 21 to the hole trap layer 24 also in the B part. This can prevent a field intensity between the A and B parts from varying according to the thickness of the field buffer layer 23, achieving a stable field buffer effect. Thus, using the bias light source 20 can enhance the field buffer effect, achieving an X-ray sensor with smaller variations in sensitivity while reducing the number of white scratches (the occurrences of white scratches) on a captured image.

Holes are unstably trapped in the hole trap layer 24. Thus, at least before X-ray irradiation, the bias light source 20 is desirably turned on to stably buffer an electric field over the sensor surface of the X-ray sensor 2.

The thickness of the field buffer layer 23 will be described below. As has been discussed, the field buffer layer of the visible light sensor has a thickness of about 30 nm, whereas in the present embodiment, the thickness of the field buffer layer 23 is larger than that of the layer composed of the light-transmissive electrode 21 and the hole injection blocking layer 22, so that the field buffer layer 23 is larger in thickness than the field buffer layer of the visible light sensor.

In other words, the field buffer layer of the visible light sensor has a thickness of about 30 nm because visible light needs to completely reach the sensitive layer in the visible light sensor, whereas in the X-ray sensor, the field buffer layer 23 can be larger in thickness than the field buffer layer of the visible light sensor because X-rays are more penetrable than visible light. In the present embodiment, the light-transmissive electrode 21 is about 30 nm in thickness and the hole injection blocking layer 22 is about 30 nm in thickness, so that the layer composed of the light-transmissive electrode 21 and the hole injection blocking layer 22 is about 60 nm in thickness. Thus, in the present embodiment, the thickness of the field buffer layer 23 is preferably set at 60 nm or larger.

In the present embodiment, also in the case where the field buffer layer 23 is larger in thickness than the field buffer layer of the visible light sensor, the use of the bias light source 20 can achieve an X-ray sensor with smaller variations in sensitivity without being affected by the history of previously captured subjects.

As has been discussed, the thickness of the field buffer layer 23 is larger than that of the layer composed of the light-transmissive electrode 21 and the hole injection blocking layer 22, so that the field buffer layer 23 is larger in thickness than the field buffer layer of the visible light sensor. This can improve the field buffer effect more than that of the visible light sensor. More preferably, the thickness of the field buffer layer 23 is set sufficiently larger than that (about 60 nm) of the layer composed of the light-transmissive electrode 21 and the hole injection blocking layer 22.

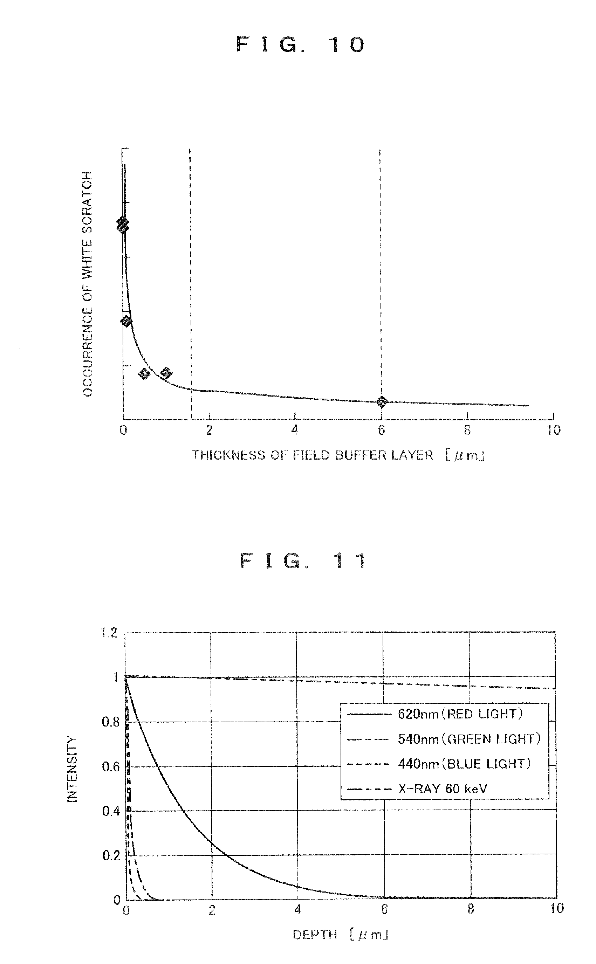

FIG. 10 shows the relationship between the thickness of the field buffer layer 23 of the X-ray sensor 2 and the number of occurrences of white scratches according to the present embodiment. The number of occurrences of white scratches in FIG. 10 is measured in the absence of X-ray or bias light irradiation. As shown in FIG. 10, the number of occurrences of white scratches rapidly decreases when the field buffer layer 23 has a thickness of 30 nm to 1.5 µm, whereas the number of occurrences of white scratches gradually decreases when the thickness of the field buffer layer 23 is larger than 1.5 µm.

Thus, the field buffer layer 23 has a thickness of at least 1.5 µm, which is sufficiently larger than that (about 60 nm) of the layer composed of the light-transmissive electrode 21 and the hole injection blocking layer 22, thereby more effectively reducing the influence of scratches or irregularities on the hole injection blocking layer 22 on the sensitive layer 25.

In the present embodiment, bias light is emitted. Thus, the thickness of the field buffer layer 23 is desirably set so as not to transmit light (bias light) from the bias light source 20 to the sensitive layer 25. Since light from the bias light source 20 does not reach the sensitive layer 25, bias light does not affect the photoelectric conversion signal even if the bias light source 20 is continuously turned on. In other words, the timing for turning on the bias light source 20 does not need to be controlled. Specifically, the bias light source 20 does not need to be turned on before X-ray irradiation or in each blanking period of X-ray radiography. The thickness of the field buffer layer 23 for preventing bias light from reaching the sensitive layer 25 varies with the wavelength of light emitted from the bias light source 20.

FIG. 11 shows the relationship between the thickness of the field buffer layer and the wavelength of light emitted from the bias light source according to the present embodiment. As shown in FIG. 11, for example, in the case where blue light having a wavelength of 440 nm and green light having a wavelength of 540 nm are emitted from the bias light source 20, the field buffer layer 23 having a thickness of at least 1 µm can prevent light from the bias light source 20 from reaching the sensitive layer 25.

Thus, as has been discussed, the number of occurrences of white scratches can be sufficiently reduced by setting the thickness of the field buffer layer 23 at 1.5 µm or larger. For example, light having a wavelength selected from the range of 440 nm to 540 nm (blue light or green light) is selected as bias light, thereby sufficiently preventing light from the bias light source 20 from reaching the sensitive layer 25.

For example, in the case where red light having a wavelength of 620 nm is emitted from the bias light source 20 as shown in FIG. 11, the field buffer layer 23 having a thickness of at least 8 µm can prevent light from the bias light source 20 from reaching the sensitive layer 25 and sufficiently reduce the number of occurrences of white scratches. As shown in FIG. 11, even if the field buffer layer 23 is at least 8 µm in thickness, X-rays substantially pass through the field buffer layer 23 without being attenuated.

As has been discussed, the field buffer layer 23 having a sufficiently large thickness can reduce the number of occurrences of white scratches and prevent bias light from reaching the sensitive layer 25. If the field buffer layer 23 has an extremely large thickness, visible light cannot pass through the field buffer layer 23. Thus, testing of the X-ray sensor 2 requires X-rays, resulting in large testing equipment including an X-ray shield mechanism. Thus, in order to facilitate testing of the X-ray sensor 2, the thickness of the field buffer layer 23 needs to be limited to allow testing with visible light.

In the present embodiment, the thickness of the field buffer layer 23 is limited to 6 µm or less, and the bias light source 20 is, for example, a light source capable of emitting visible light having a wavelength of 440 nm (blue) or 540 nm (green). As shown in FIG. 11, for example, red light can pass through the field buffer layer 23 up to a thickness of about 6 µm, allowing testing of the X-ray sensor 2 by using red light having a wavelength of 620 nm that is visible light.

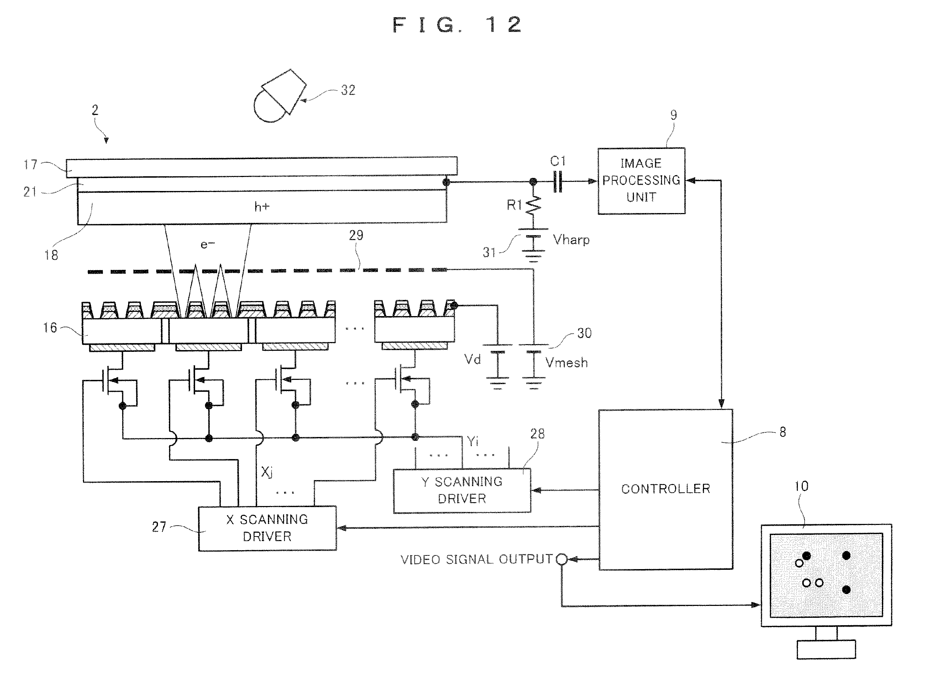

Referring to FIG. 12, a method for testing the X-ray sensor 2 will be described below according to the present embodiment. FIG. 12 is a control block diagram in the testing of the X-ray sensor with red light.

First, a voltage is applied to the light-transmissive electrode 21 so as to apply an electric field of 50 V/µm to 100 V/µm to the photoconductive film 18. In this state, red light having a wavelength of 620 nm is evenly emitted to the overall X-ray incidence surface of the light-transmissive substrate 17 from a light source 32 (first step).

The red light is incident on the sensitive layer 25 and thus generates charge on the sensitive layer 25. Subsequently, the electron source 16 is controlled by the X scanning driver 27 and the Y scanning driver 28 so as to scan electron beams on the surface of the electron injection blocking layer 26 of the photoconductive film 18. By scanning electron beams, an electric signal corresponding to the amount of charge generated on the sensitive layer 25 by the irradiation of red light, that is, an electric signal corresponding to the intensity of the red light incident on the sensitive layer 25 is read to the image processing unit 9 (second step).

The read electric signal is subjected to image processing by the image processing unit 9 and then is displayed as a video signal on the monitor 10 by the controller 8. Consequently, white scratches and black scratches are displayed as they are on the display screen of the monitor 10. Thus, scratches on the photoconductive film 18 can be evaluated using red light that is visible light.

As has been discussed, according to the present embodiment, the field buffer layer 23 is sufficiently larger in thickness than the field buffer layer of the visible light sensor. Thus, even if scratches or irregularities occur on the hole injection blocking layer 22, an electric field can be effectively buffered to reduce the number of white scratches (the number of occurrences of white scratches) on a captured image.

Moreover, according to the present embodiment, even if the field buffer layer 23 has a larger thickness, the use of the bias light source 20 can achieve an X-ray sensor with smaller variations in sensitivity without being affected by the history of previously captured subjects.

Furthermore, according to the present embodiment, red light having a wavelength of 620 nm that is visible light can be used when the quality of the X-ray sensor 2 is evaluated. Thus, the X-ray sensor 2 can be more easily evaluated than in the use of X-rays.

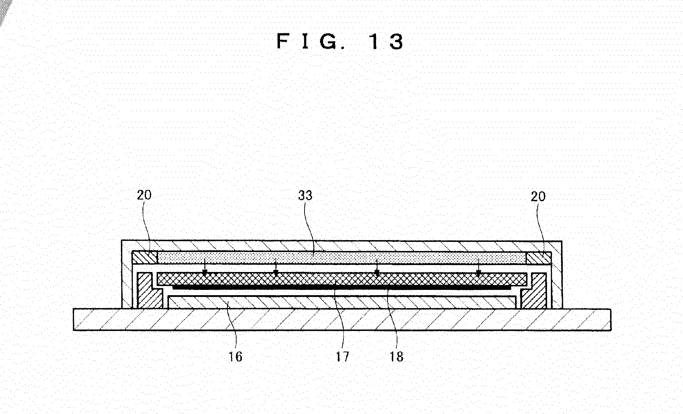

Another embodiment of the X-ray sensor will be described below. As shown in FIG. 13, an X-ray sensor 2 according to the other embodiment is different from the foregoing embodiment in that a light guide plate 33 is placed above a light-transmissive substrate 17. In other words, in the other embodiment, light (bias light) from a bias light source 20 is incident on a side of the light guide plate 33 as illustrated in FIG. 13. The light received by the light guide plate 33 from the bias light source 20 is then evenly emitted to the overall X-ray incidence surface of the light-transmissive substrate 17. Hence, a hole trap layer 24 can be evenly irradiated with the bias light.

The foregoing embodiments can be changed in various ways without substantially departing from the scope of the effect of the present invention.

### Industrial Applicability

An X-ray sensor and an X-ray diagnostic device equipped with the X-ray sensor according to the present invention can reduce the number of white scratches caused by scratches or irregularities on a hole injection blocking layer. Moreover, a method for testing the X-ray sensor according to the present invention can evaluate the quality of the X-ray sensor by using red light having a wavelength of 620 nm that is visible light. Thus, the quality of the X-ray sensor can be more easily evaluated than in a testing method using X-rays. For this reason, the X-ray sensor, the method for testing the X-ray sensor, and the X-ray diagnostic device equipped with the X-ray sensor according to the present invention are useful for devices for observing the internal condition of a test subject with X-rays.

### Reference Signs List

- 1: X-ray source
- 2: X-ray sensor
- 3: subject
- 4: arm
- 5: bed
- 6: main unit case
- 7: X-ray control unit
- 8: controller
- 9: image processing unit
- 10: monitor
- 11: electron source control unit
- 12: bias light-source control unit
- 13: movement control unit
- 14: input unit
- 15: mounting substrate
- 16: electron source
- 17: light-transmissive substrate
- 18: photoconductive film
- 19: cover
- 20: bias light source
- 21: light-transmissive electrode
- 22: hole injection blocking layer
- 23: field buffer layer
- 24: hole trap layer
- 25: sensitive layer
- 26: electron injection blocking layer
- 27: X scanning driver
- 28: Y scanning driver
- 29: mesh
- 30: mesh voltage applying unit
- 31: high voltage source
- 32: light source
- 33: light guide plate

## Claims

1. An X-ray sensor comprising:
a light-transmissive substrate;
a light-transmissive electrode formed on a first surface of the light-transmissive substrate; and
a photoconductive film including a hole injection blocking layer, a field buffer layer, a hole trap layer, a photoconductive sensitive layer having a charge-multiplying function, and an electron injection blocking layer, the layers being sequentially provided on the first surface of the light-transmissive substrate having the light-transmissive electrode,
wherein the field buffer layer is larger in thickness than a layer composed of the light-transmissive electrode and the hole injection blocking layer.

2. The X-ray sensor according to claim 1, wherein the field buffer layer is at least 60 nm in thickness.

3. The X-ray sensor according to claim 1, wherein the field buffer layer is at least 1.5 µm in thickness.

4. The X-ray sensor according to claim 1, wherein the field buffer layer is 1.5 µm to 6 µm in thickness.

5. The X-ray sensor according to any one of claims 1 to 4, further comprising an electron source that irradiates a surface of the electron injection blocking layer of the photoconductive film with an electron beam.

6. The X-ray sensor according to any one of claims 1 to 5, further comprising a bias light source that irradiates a second surface of the light-transmissive substrate with light, the second surface being located opposite to the first surface so as to receive X-rays.

7. The X-ray sensor according to claim 6, wherein the bias light source is located outside a projection region of the light-transmissive substrate.

8. The X-ray sensor according to claim 6, further comprising a cover containing the light-transmissive substrate, the bias light source being disposed in the cover.

9. The X-ray sensor according to any one of claims 6 to 8, wherein the field buffer layer is so thick as to prevent light from the bias light source from reaching the sensitive layer.

10. The X-ray sensor according to any one of claims 6 to 8, wherein the bias light source emits light having a wavelength selected from a range of 440 nm to 540 nm, and the field buffer layer is at least 1 µm in thickness.

11. The X-ray sensor according to claim 10, wherein the field buffer layer is not larger than 6 µm in thickness.

12. A method for testing the X-ray sensor according to any one of claims 1 to 11,
the method comprising:
a first step of, in a state in which the light-transmissive electrode is fed with a voltage so as to apply an electric field to the photoconductive film, emitting red light to the second surface of the light-transmissive substrate, the second surface being located opposite to the first surface so as to receive X-rays; and
a second step of collecting an electric signal from the photoconductive film according to an amount of charge generated on the sensitive layer of the photoconductive film by the irradiation of the red light.

13. An X-ray diagnostic device comprising:
an X-ray source; and
the X-ray sensor according to any one of claims 1 to 11, the X-ray sensor being located at a predetermined distance from the X-ray source so as to be opposed to the X-ray source.
